Europäisches Patentamt

European Patent Office

Office européen des brevets

(11) Veröffentlichungsnummer: **0 340 521 B1**

(12) **EUROPÄISCHE PATENTSCHRIFT**

(45) Veröffentlichungstag der Patentschrift: **11.11.92**

(21) Anmeldenummer: **89106880.1**

(22) Anmeldetag: **17.04.89**

(51) Int. Cl.⁵: **H01L 23/46**, H05K 7/20

(54) **Anordnung zur Kühlung von elektronischen Bauelementen, insbesondere von integrierten Halbleiterschaltungen, mit einem flüssigen Kühlmittel.**

(30) Priorität: **05.05.88 DE 3815386**

(43) Veröffentlichungstag der Anmeldung:
**08.11.89 Patentblatt 89/45**

(45) Bekanntmachung des Hinweises auf die
Patenterteilung:
**11.11.92 Patentblatt 92/46**

(84) Benannte Vertragsstaaten:
**AT BE CH DE FR GB IT LI NL**

(56) Entgegenhaltungen:
**US-A- 4 381 032**

(73) Patentinhaber: **RICHTER, Hans-Jürgen**
**Moosen 23**
**W-8201 Riedering(DE)**

(72) Erfinder: **Richter, Hans-Jürgen, Dipl.-Ing.**
**Moosen 23**
**W-8201 Riedering(DE)**

(74) Vertreter: **Fuchs, Franz-Josef, Dr.-Ing. et al**
**Postfach 22 13 17**
**W-8000 München 22(DE)**

**Beschreibung**

Die Erfindung betrifft eine Anordnung zur Kühlung von in Gruppen auf Leiterplatten angeordneten elektronischen Bauelementen, insbesondere von integrierten Halbleiterschaltungen, mit einem flüssigen Kühlmittel, das durch einen auf der Bauelementgruppe angeordneten Kühlkörper geführt wird.

Eine Kühlvorrichtung zur Kühlung von elektronischen Bauelementen mit einem durch einen Kühlkörper geführten flüssigen Kühlmittel ist aus der deutschen Patentschrift DE 29 03 685 C2 bekannt. Der Kühlkörper ist aus zwei miteinander verschweißten Kunststoff-Folien gebildet und liegt mit einer Seitenfläche an der Oberfläche der zu kühlenden Bauelemente an. Als Folie kann auch eine Verbundfolie verwendet werden, die insbesondere auch eine Metallschicht enthält. Aufgrund der Gestaltung des Kühlkörpers ist die Anwendung dieser Kühlvorrichtung auf mit ihren Flachseiten nebeneinander angeordneten Flachbaugruppen beschränkt. Zur Vermeidung von Sicherheitsrisiken bei Leckwerden der Kunststoff-Folie ist der Kühlbehälter in einen Überbeutel aus Kunststoff eingeschlossen.

Aufgabe der Erfindung ist es, eine Anordnung zur Kühlung von in Gruppen auf Leiterplatten angeordneten elektronischen Bauelementen mit einem flüssigen Kühlmittel anzugeben, die für alle Bauelemente-Bauformen und für Bauelememtgruppen verschiedenster Zusammensetzung geeignet ist. Die Anordnung soll so geschaffen sein, daß die standardmäßigen Fertigungs- und Montagetechniken für die bestückten Leiterplatten und die, die einzelnen Leiterplatten aufnehmenden Verdrahtungsträger, beibehalten werden können.

Diese Aufgabe wird durch eine Anordnung der eingangs genannten Art dadurch gelöst, daß

a) der Kühlkörper aus einer auf einem Rahmen befestigten Kunststoff-Metall-Verbundfolie und einer auf dieser angeordneten, im Randbereich entlang des Umfangs fest und dicht mit dieser verbundenen festen Platte besteht,

b) die Kunststoff-Metall-Verbundfolie eine durch Tiefziehen erzeugte Ausformung zur Aufnahme des Kühlmittels aufweist,

c) die feste Platte Versorgungskanäle und mindestens einen Zu-und einen Abfluß für das Kühlmittel aufweist,

d) der Kühlkörper mit der durch die Kunststoff-Metall-Verbundfolie gebildeten Außenfläche auf den zu kühlenden auf der Leiterplatte befindlichen Bauelementgruppen angeordnet ist und

e) im Innern des Kühlkörpers eine Druckmatte mit einer der Anordnung der zu kühlenden Bauelemente angepassten gitterartigen Struktur mit Erhebungen an den Gitterpunkten so zwischen der Kunststoff-Metall-Verbundfolie und der festen Platte angeordnet ist, daß die Kunststoff-Metall-Verbundfolie durch die Erhebungen an die einzelnen Bauelemente angedrückt ist.

Die erfindungsgemäße Anordnung weist gegenüber dem Stand der Technik folgende verbesserte Eigenschaften auf:

1. Die Wärmeableitung von den zu kühlenden Bauelementen zu den Kühlkörper durchströmenden Kühlmittel ist besonders gut. Durch Verwendung einer tiefgezogenen Kunststoff-Metall-Verbundfolie weist der Kühlkörper vorgeformte Ausformungen auf, die nicht durch den Flüssigkeitsdruck des Kühlmittel geschaffen werden müssen. Dadurch wird die Verwendung einer Kunststoff-Metall-Verbundfolie mit relativ dicker Metallschicht möglich, wodurch die Wärmeableitung von den Bauelementen zum Kühlmittel verbessert ist. Eine Ausgestaltung der Erfindung sieht eine Kunststoff-Metall-Verbundfolie vor, die der Form und Lage der Bauelemente angepasste, durch Tiefziehen geschaffene Ausformungen aufweist. Dadurch wird der Wärmekontakt an der Grenzfläche der Bauelementgruppenoberfläche zur Kunststoff-Metall-Verbundfolie stark verbessert. Weitere besonders vorteilhafte Ausgestaltungen der Erfindung weisen eine Kunststoff-Metall-Verbundfolie mit der Schichtenfolge Polypropylen, Aluminium, Polypropylen oder eine Kunststoff-Metall-Verbundfolie mit einer der Bauelementoberfläche zugewandten Schicht aus Polyimid auf. Solche Verbundfolien haben besonders gute Tiefzieheigenschaften und eine gute Kerbfestigkeit bei gleichzeitig guter Wärmeleitfähigkeit. Aufgrund dieser vorteilhaften Eigenschaften ist die Anordnung zur Kühlung von Bauelementen mit niedriger bis sehr hoher Verlustleistung geeignet.

2. Die relativ dicke tiefgezogene Kunststoff-Metall-Verbundfolie ist gegenüber einer Kerbbeanspruchung an der Kontaktfläche zu den Bauelementen wesentlich unempfindlicher als eine reine Kunststoff-Folie, die durch den Kühlmitteldruck ausgeformt werden muß. Die Belastung der Kunststoff-Metall-Verbundfolie durch den Flüssigkeitdruck des Kühlmittels kann reduziert werden, da er nicht zur Bildung der Ausformungen der Kunststoff-Metall-Verbundfolie und zum Andrücken des Kühlkörpers an die zu kühlende Bauelementgruppenoberflächebenötigt wird. Der Kühlkörper weist außerdem keine Schweißnähte zwischen Kunststoffteilen auf, die bei hohem Druck leck werden könnten. Ein Sicherheitsbeutel, der den Kühlkörper aufnimmt, kann entfallen. Die der Lage und Form der zu kühlenden Bauelemente angepasst ausgeformte Kunststoff-Metall-Verbundfolie erfährt eine geringere Kerbbeanspruchung an der Grenzfläche zur Bauelementoberfläche.

3. Der Verlust an effektiver Bestückungsfläche der die Bauelemente tragenden Leiterplatte ist durch die optimale Anpassung des Kühlkörpers an die Oberfläche der zu kühlenden Bauelementgruppen gering.

4. Die äußeren Maße der Kühlanordnung sind aufgrund der optimalen Anpassung des Kühlkörpers an die Oberfläche der zu kühlenden Bauelementgruppen ebenfalls gering.

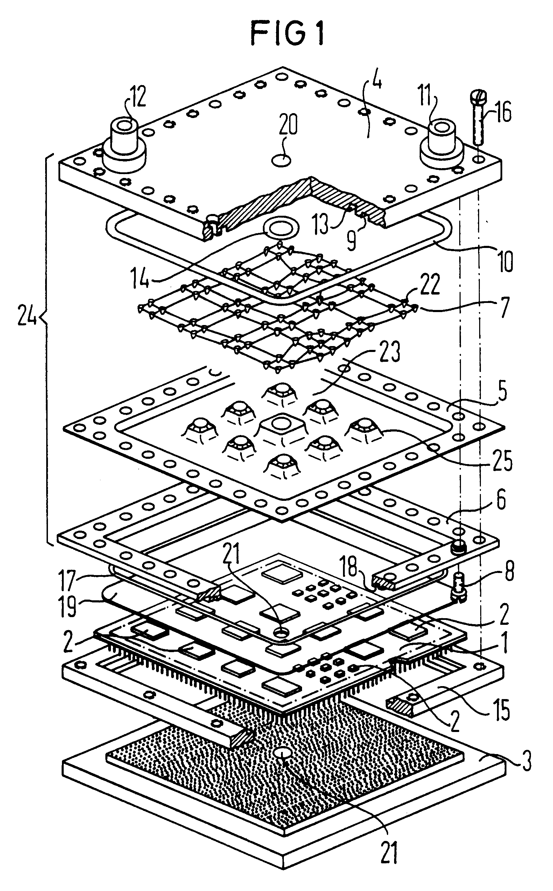

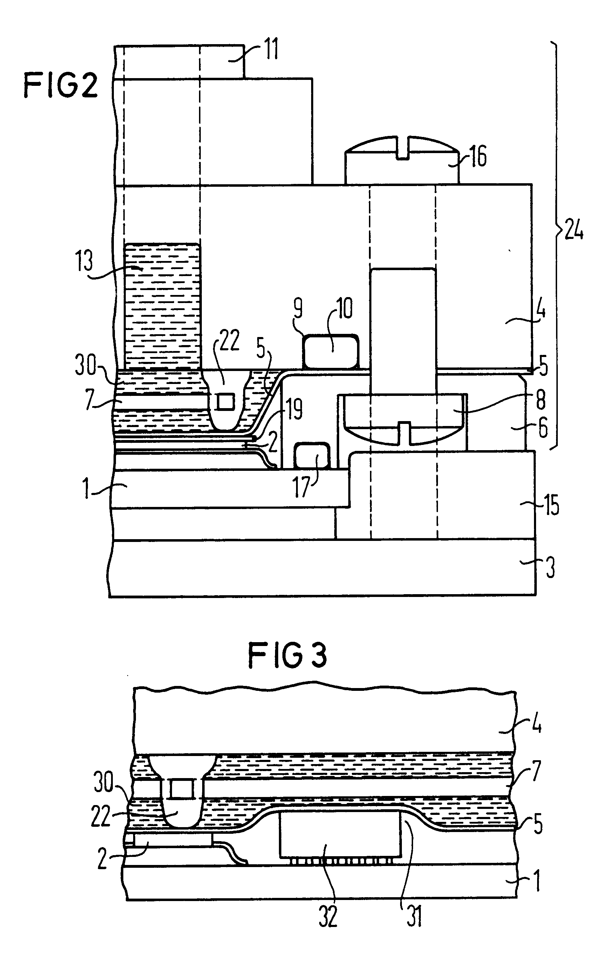

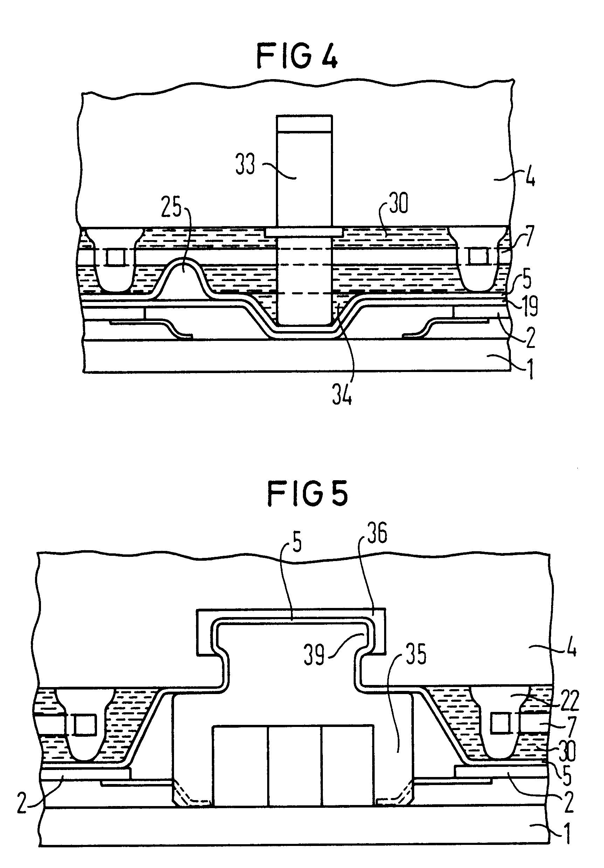

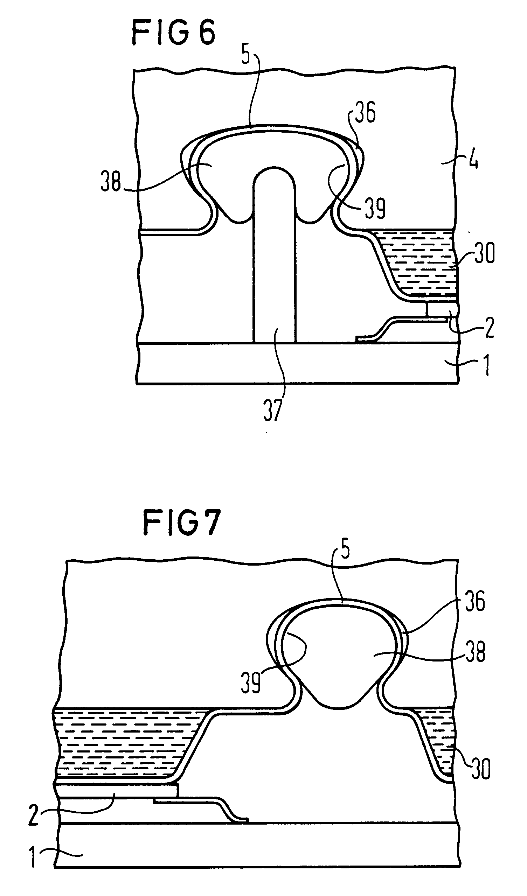

Weitere Ausgestaltungen der Erfindung ergeben sich aus den Unteransprüchen und der anhand von Ausführungsbeispielen mit Figuren 1 bis 7 gegebenen Beschreibung.

Die Figuren der nachfolgend beschriebenen Ausführungsbeispiele zeigen in schematischer Darstellung:

FIG 1 eine Anordnung zur Kühlung einer auf einer Leiterplatte angeordneten Gruppe elektronischer Bauelemente als Explosionsdarstellung,

FIG 2 einen vergrößerten Ausschnitt der Anordnung aus FIG 1 in zusammengesetztem Zustand,

FIG 3 einen Ausschnitt einer Anordnung mit einer der Form und Lage eines zu kühlenden Bauelements angepassten Kühlkörpers,

FIG 4 einen Ausschnitt einer Anordnung mit einem an der festen Platte des Kühlkörpers befestigten Abstandshalter zwischen Kühlkörper und Leiterplatte,

FIG 5 einen Ausschnitt einer Anordnung mit einem an der festen Platte befestigten Abstandshalter zwischen Kühlkörper und Leiterplatte,

FIG 6 einen Ausschnitt einer weiteren Anordnung mit einem an der Leiterplatte befestigten Abstandshalter zwischen Kühlkörper und Leiterplatte,

FIG 7 einen Ausschnitt einer Anordnung mit einem Kühlkörper, der eine Fixierung der Kunststoff-Metall-Verbundfolie an der festen Platte durch ein eingepresstes Kunststoffteil aufweist. Gleiche Teile sind in den FIG mit demselben Bezugzeichen versehen.

FIG 1

Eine Leiterplatte 1, die auf einen PGA-Stecker (PGA = Pin Grid Array) 3 gesteckt ist, weist verschiedene zu kühlende Bauelemte 2 auf. Der Kühlkörper 24 setzt sich zusammen aus der festen Platte 4, der auf einem Rahmen 6 angeordneten Kunststoff-Metall-Verbundfolie 5 und der zwischen der festen Platte 4 und der Kunststoff-Metall Verbundfolie 5 angeordneten Druckmatte 7. Die feste Platte 4 ist mit dem Rahmen 6 durch Schrauben 8 verbunden. Zur Abdichtung des Kühlkörpers 24 ist ein Dichtungsring 10 zwischen Kunststoff-Metall Verbundfolie 5 und fester Platte 4 vorgesehen, der in eine auf der Innenseite der festen Platte 4 vorgesehene Nut 9 eingelegt ist

Der PGA-Stecker 3 verbindet die Leiterplatte 1 mit der nächsthöheren Hirarchieebene eines komplexen Aufbaues (nicht in der FIG dargestellt).

Zur Befestigung des Kühlkörpers 24 auf den zu kühlenden Baueleten 2 ist ein Klemmrahmen 15 vorgesehen, der die Leiterplatte 1 umfasst. Der Kühlkörper 24 ist durch Schrauben 16 auf dem Klemmrahmen 15 befestigt. Der Klemmrahmen 15 ist entweder mit dem PGA-Stecker oder einem Träger der nächsthöheren Hirarchieebene fest verbunden.

Die Anordnung kann so ausgestaltet sein, daß eine Dichtung 17 zwischen Kühlkörper 24 und Leiterplatte 1 vorgesehen ist, die in einer zur Leiterplatte 1 hin ausgerichteten Nut 18 im Rahmen 6 angeordnet ist. Eine solche Ausgestaltung dient dem Schutz der Bauelemente vor Verunreinigungen durch die Umgebung und zusätzlich zur Schadensbegrenzung bei eventuellem Leckwerden des Kühlkörpers (Failsafe). Außerdem kann eine Schutzfolie 19 (durchsichtig gezeichnet), z.B. aus Metall, zwischen der Oberfläche der Bauelemente 2 und dem Kühlkörper 24 angeordnet sein. Der Kühlkörper 24 kann Bohrungen 20 mit einer Dichtung 14 zur gemeinsamen Montage der Leiterplatte 1 mit dem Kühlkörper 24 und dem PGA-Stecker 3 auf einem Träger (nicht in der FIG dargestellt) aufweisen. Dazu sind in der Leiterplatte 1 und dem PGA-Stecker Bohrungen 21 vorgesehen.

Die feste Platte 4 weist einen Zulauf 11, einen Ablauf 12 und Versorgungskanäle 13 für das Kühlmittel auf.

Die Druckmatte 7 hat eine gitterartige Struktur mit Erhebung 22 an den Gitterpunkten, die der Lage der Bauelemente 2 entsprechen. Die Druckmatte 7 kann so ausgestaltet sein, daß mehrere Erhebungen 22 über einem Bauelement 2 angeordnet sind. Die Druckmatte 7 ist aus einem gut wärmeleitfähigen Material, z.B. einem gefüllten Elastomer, hergestellt. Die Erhebungen 22 können auch aus einem weiteren gut wärmeleitfähigen Material sein, z.B. Metalldruckfedern. Die Erhebungen 22 sollen elastisch sein, um den Druck, der auf die Bauelemente 2 wirkt, möglichst gleichmäßig über alle Bauelemente 2 zu verteilen. In zusammengesetztem Zustand der Anordnung wird die Kunststoff-Metall-Verbundfolie 5 durch die Erhebungen 22 an die Bauelemente angedrückt.

Die Kunststoff-Metall-Verbundfolie 5 weist eine durch Tiefziehen, z.B. Vakuum-Tiefziehen, erzeugte Ausformung 23 zur Führung des Kühlmittels 30 und in den Innenraum des Kühlkörpers 24 gerichtete Ausformungen 25, durch die Drosselstrecken für den Kühlmittelfluß gebildet werden, auf. Die Schutzfolie 19 kann zum Schutz der Kunststoff-Metall-Verbundfolie 5 gegen scharfkantige Bauelemente oder bei Verwendung einer Metallfolie zum Anlegen eines konstanten elektrischen Potentials an die Bauelementoberfläche eingesetzt werden. Zur Übersicht sind die feste Platte 4, der Rahmen 6, die Kunststoff-Metall-Verbundfolie 5 und der Klemmrahmen 15 angeschnitten dargestellt.

FIG 2

Die Darstellung zeigt einen vergrößerten Ausschnitt des Randbereichs einer Kühlanordnung. Die mit den PGA-Stecker 3 verbundene Leiterplatte 1 trägt ein Bauelement 2, das mit einer Schutzfolie 19 bedeckt ist. Die Kunststoff-Metall-Verbundfolie 5 wird durch die Erhebung 22 der Druckmatte 7 an das Bauelement 2 angedrückt. Das zwischen der festen Platte 4 und der Kunststoff-Metall-Verbundfolie 5 befindliche Kühlmittel 30 wird durch den Zulauf 11 über den Versorgungskanal 13 zugeführt. Durch die Verschraubung 16 wird die feste Platte 4 mit dem Rahmen 6, auf dem sich die Kunststoff-Metall-Verbundfolie 5 befindet, fest verbunden. Dabei wird der Kühlkörper 24 durch einen in der Nut 9 der festen Platte angeordneten Dichtungsring 10 abgedichtet. Der Kühlkörper 24 ist durch Schrauben 16 auf dem Klemmrahmen 15 befestigt, der die Leiterplatte 1 umspannt.

FIG 3

Bei Anwendung der Kühlanordnung zur Kühlung von Bauelementen 32 mit besonderer Bauhöhe kann in der Kunststoff-Metall-Verbundfolie 5 des Kühlkörpers 24 eine der Form und Lage des Bauelements 32 angepassten Ausformung 31 geschaffen sein. Dadurch wird der Wärmekontakt des Kühlkörpers zum Bauelement 32 verbessert und die Kunststoff-Metall-Verbundfolie 5 vor mechanischer Beanspruchung geschützt.

Zur Anpassung des Kühlkörpers an die mit Bauelementen bestückte Leiterplattenoberfläche sind noch weitere Ausformungen in der Kunststoff-Metall-Verbundfolie denkbar, z.B. für Oberflächenbereiche mit diskreten Verdrahtungen (nicht in der FIG dargestellt).

Die von der Bauelementbestückung der Leiterplatte abhängigen Ausformungsmuster der Kunststoff-Metall-Verbundfolie können mit CAD/CAM-Unterstückung erzeugt werden ( = Computer Aided Design bzw. Manufactoring).

FIG 4

Bei großen zu kühlenden Oberflächen von Bauelementgruppen kann es vorteilhaft sein, einen Abstandshalter 33 zwischen fester Platte 4 und Kunststoff-Metall-Verbundfolie 5, z. B. zur Durchbiegungsbegrenzung, vorzusehen. Der Abstandshalter 33 kann dabei, z. B. durch Verschraubung, mit der festen Platte fest verbunden sein und in eine nach außen gerichtete Ausformung 34 der Kunststoff-Metall-Verbundfolie 5 geschaffene Ausformung hineinragen. Der Abstandshalter 33 muß so positioniert sein, daß er nach Befestigen des Kühlkörpers auf der Leiterplatte an einer nicht mit Bauelementen bestückten Stelle der Leiterplatte angeordnet ist. Der Abstandshalter 33 kann zum Schutz der Kunststoff-Metall-Verbundfolie 5 fest mit dieser verbunden sein, z. B. durch Klebung, was sich insbesondere beim Transport des Kühlkörpers 24 vorteilhaft auswirkt. In den Innenraum des Kühlkörpers 24 gerichtete Ausformungen 25 der Kunststoff-Metall-Verbundfolie sind so angeordnet und geformt, daß sie zur Führung des Kühlmittels 30 dienen und Drosselstrecken für den Kühlmittelfluß bilden.

FIG 5

Zur Abstandssicherung zwischen Leiterplatte 1 und fester Platte 4 kann auch ein an der Leiterplatte 1 angeordneter Abstandshalter 35 vorgesehen sein, der in eine in der festen Platte 4 geschaffene Aushöhlung 36 hineinragt und dabei gleichzeitig die Kunststoff-Metall-Verbundfolie 5 in der Aushöhlung 36 fixiert. Bei einer solchen als Bajonett-Verschluß 4/5/35 gestalteten Abstandssicherung ist eine Formung der Kunststoff-Metall-Verbundfolie 5 vor dem Verbinden der Abstandshalter 35 mit der festen Platte 4 nicht notwendig. Das Schließen des Bajonett-Verschlusses 4/5/35 bewirkt sozusagen ein Montagetiefziehen der Kunststoff-Metall-Verbundfolie 5 bei der Drehung des Abstandshalters 35.

FIG 6

Die Kunststoff-Metall-Verbundfolie 5 kann auch in der Aushöhlung 36 der festen Platte durch ein eingepresstes Kunststoffteil 38 fixiert sein, das mit dem an der Leiterplatte 1 befestigten weiteren Abstandshalter 37 verbunden ist.

FIG 7

Die Fixierung der Kunststoff-Metall-Verbundfolie 5 an die feste Platte 4 kann auch ohne Abstandshalter zur Leiterplatte 1 erfolgen, indem die Kunststoff-Metall-Verbundfolie 5 durch ein entsprechendes Kunststoffteil 38 in die Aushöhlung 36 der festen Platte 4 eingepresst ist.

Der Gegenstand der Erfindung beinhaltet auch eine Anordnung zur Kühlung von Bauelementgruppen, die auf beidseitig mit einem PGA-Stecker auf einer Trägerleiterplatte befestigten Leiterplatten angeordnet sind, wobei auf beiden Leiterplatten auf den zu kühlenden Bauelementgruppen ein Kühlkörper angeordnet ist und die Kühlkörper mit einem gemeinsamen Klemmrahmen befestigt sind (nicht in den Figuren dargestellt).

## Patentansprüche

1. Anordnung zur Kühlung von in Gruppen auf Leiterplatten angeordneten elektronischen Bauelementen, insbesondere von integrierten Halbleiterschaltungen,mit einem flüssigen Kühlmittel, das durch einen auf der Bauelementgruppe angeordneten Kühlkörper geführt wird, wobei
a) der Kühlkörper (24) aus einer auf einem Rahmen (6) befestigten Kunststoff-Metall-Verbundfolie (5) und einer auf dieser angeordneten, im Randbereich entlang des Umfangs fest und dicht mit dieser verbundenen festen Platte (4) besteht,
b) die Kunststoff-Metall-Verbundfolie (5) eine durch Tiefziehen erzeugte Ausformung (23) zur Aufnahme des Kühlmittels (30) aufweist,
c) die feste Platte (4) Versorgungskanäle (13) und mindestens einen Zu- (11) und einen Abfluß (12) für das Kühlmittel (30) aufweist,
d) der Kühlkörper mit der durch die Kunststoff-Metall-Verbundfolie (5) gebildeten Außenfläche auf den zu kühlenden auf der Leiterplatte (1) befindlichen Bauelementgruppen (2, 32) angeordnet ist und
e) im Innern des Kühlkörpers (24) eine Druckmatte (7) mit einer der Anordnung der zu kühlenden Bauelemente (2, 32) angepassten gitterartigen Struktur mit Erhebungen (22) an den Gitterpunkten so zwischen der Kunststoff-Metall-Verbundfolie (5) und der festen Platte (4) angeordnet ist, daß die Kunststoff-Metall-Verbundfolie (5) durch die Erhebungen (22) an die einzelnen Bauelemente (2) angedrückt ist.

2. Anordnung nach Anspruch 1, **dadurch gekennzeichnet,** daß die Kunststoff-Metall Verbundfolie (5) in den Innenraum des Kühlkörpers (24) gerichtete Ausformungen (31) aufweist, die der Form und Lage der zu kühlenden Bauelemente (32) angepasst sind.

3. Anordnung nach einem der Ansprüche 1 oder 2, **dadurch gekennzeichnet,** daß die Kunststoff-Metall-Verbundfolie (5) weitere In den Innenraum des Kühlkörpers (24) gerichtete Ausformungen (25) aufweist, so daß Drosselstrecken für den Kühlmittelfluß gebildet werden.

4. Anordnung nach einem der Ansprüche 1 bis 3, **dadurch gekennzeichnet,** daß die Kunststoff-Metall-Verbundfolie (5) die Schichtenfolge Polypropylen, Aluminium, Polypropylen aufweist.

5. Anordnung nach einem der Ansprüche 1 bis 3, **dadurch gekennzeichnet,** daß die Kunststoff-Metall-Verbundfolie (5) eine Oberflächenschicht aus Polyimid aufweist, die auf den zu kühlenden Bauelementen (2, 32) angeordnet ist.

6. Anordnung nach einem der Ansprüche 1 bis 5, **dadurch gekennzeichnet,** daß der Kühlkörper (24) mittels eines am äußeren Umfang der die Bauelementgruppen (2) tragenden Leiterplatte (1) angeordneten Klemmrahmens (15) auf den Bauelementgruppen (2) befestigt ist.

7. Anordnung nach Anspruch 6, **dadurch gekennzeichnet,** daß eine Dichtung (17) zwischen Kühlkörper und Leiterplatte (1) dadurch vorgesehen ist, daß der die Kunststoff-Metall-Verbundfolie (5) tragende Rahmen (6) eine zur Leiterplatte (1) hin ausgerichtete Nut (9) aufweist, die einen Dichtungsring (17) enthält.

8. Anordnung nach einem der Ansprüche 1 bis 7, **dadurch gekennzeichnet,** daß im Innern des Kühlkörpers (24) zwischen der festen Platte (4) und der Kunststoff-Metall-Verbundfolie (5) ein an der festen Platte (4) befestigter Abstandshalter (33) vorgesehen ist, der in eine nach außen gerichtete Ausformung (34) der Kunststoff-Metall-Verbundfolie (5) hineinragt.

9. Anordnung nach einem der Ansprüche 1 bis 8, **dadurch gekennzeichnet,** daß der Kühlkörper (24) eine abgedichtete Durchbohrung (20) zur gemeinsamen Montage mit Leiterplatte (1) auf einem Träger aufweist.

10. Anordnung nach einem der Ansprüche 1 bis 9, **dadurch gekennzeichnet,** daß ein auf der Leiterplatte (1) angeordneter Abstandshalter (35) zwischen Leiterplatte (1) und fester Platte (4) vorgesehen ist und an entsprechender Stelle des Kühlkörpers (24) eine Ausnehmung (36) in der festen Platte (4) und eine weitere in den Innenraum des Kühlkörpers (24) gerichtete, in die Ausnehmung (36) der festen Platte (4) ragende Ausformung (39) der Kunststoff-Metall-Verbundfolie (5) vorgesehen ist.

11. Anordnung nach einem der Ansprüche 1 bis 10, **dadurch gekennzeichnet,** daß die Kunststoff-Metall-Verbundfolie (5) an einer Stelle ihrer Innenflächen an die feste Platte (4) mittels eines Kunststoffteils (38) fixiert ist, das in eine weitere in den Innenraum des Kühlkörpers (24) gerichtete Ausformung (39) der Kunststoff-Metall-Verbundfolie (5) eingepresst ist, die in eine auf der Innenfläche der festen Platte (4) geschossene Ausnehmung (36) ragt.

**12.** Anordnung nach Anspruch 11, **dadurch gekennzeichnet,** daß das eingepresste Kunststoffteil (38) mit einem weiteren auf der Leiterplatte (1) angeordnetem Abstandshalter (37) verbunden ist.

**13.** Anordnung nach einem der Ansprüche 1 bis 12, **dadurch gekennzeichnet,** daß zwischen dem Kühlkörper (24) und der die Bauelementgruppen (2) tragenden Leiterplatte (1) eine Schutzfolie (19) angeordnet ist.

## Claims

**1.** Arrangement for cooling electronic components, in particular integrated semiconductor circuits, arranged in groups on conductor boards, with a liquid coolant which is passed through a heat sink arranged on the group of components, in which
  a) the heat sink (24) is composed of a plastic/metal composite film (5) mounted on a frame (6) and a rigid panel (4) arranged on the former and firmly and tightly joined to the former in the edge region along the periphery,
  b) the plastic/metal composite film (5) has a contour (23) produced by deep-drawing for receiving the coolant (30),
  c) the rigid panel (4) has supply channels (13) and at least one inlet (11) and one outlet (12) for the coolant (30),
  d) the heat sink is arranged with the outside surface formed by the plastic/metal composite film (5) on the component groups (2, 32) to be cooled and situated on the conductor board (1) and,
  e) in the interior of the heat sink (24), a pressure mat (7) having a grid-like structure which is matched to the arrangement of the components (2, 32) to be cooled and which has projections (22) at the lattice nodes is arranged between the plastic/metal composite film (5) and the rigid panel (4) in a manner such that the plastic/metal composite film (5) is pressed against the individual components (2) by the projections (22).

**2.** Arrangement according to Claim 1, characterized in that the plastic/metal composite film (5) has contours (31) which are directed into the interior of the heat sink (24) and which are matched to the shape and position of the components (32) to be cooled.

**3.** Arrangement according to one of the Claims 1 or 2, characterized in that the plastic/metal composite film (5) has further contours (25) directed into the interior of the heat sink (24) so that restriction paths are formed for the coolant flow.

**4.** Arrangement according to one of Claims 1 to 3, characterized in that the plastic/metal composite film (5) has a layer sequence comprising polypropylene, aluminium, polypropylene.

**5.** Arrangement according to one of Claims 1 to 3, characterized in that the plastic/metal composite film (5) has a polyimide surface layer which is arranged on the components (2,32) to be cooled.

**6.** Arrangement according to one of Claims 1 to 5, characterized in that the heat sink (24) is mounted on the component groups (2) by means of a clamping frame (15) arranged at the outer periphery of the conductor board (1) carrying the component groups (2).

**7.** Arrangement according to Claim 6, characterized in that a seal (17) is provided between heat sink and conductor board (1), in that the frame (6) carrying the plastic/metal composite film (5) has a groove (9) which is directed towards the conductor board (1) and which contains a sealing ring (17).

**8.** Arrangement according to one of Claims 1 to 7, characterized in that, in the interior of the heat sink (24) between the rigid panel (4) and the plastic/metal composite film (5) a spacer (33) is provided which is mounted on the rigid panel (4) and which projects into an outwardly directed contour (34) of the plastic/metal composite film (5).

**9.** Arrangement according to one of Claims 1 to 8, characterized in that the heat sink (24) has a sealed drilled hole (20) for common assembly with conductor board (1) on a carrier.

**10.** Arrangement according to one of Claims 1 to 9, characterized in that a spacer (35) arranged on the conductor board (1) is provided between conductor board (1) and rigid panel (4) and, at a corresponding point in the heat sink (24), a recess (36) is provided in the rigid panel (4) and a further contour (39) of the plastic/metal composite film (5) is provided which is directed into the interior of the heat sink (24) and projects into the recess (36) of the rigid panel (4).

11. Arrangement according to one of Claims 1 to 10, characterized in that the plastic/metal composite film (5) is locked in position at a point on its inside face on the rigid panel (4) by means of a plastic part (38) which is pressed into a further contour (39) of the plastic/metal composite film (5) which is directed into the interior of the heat sink (24) and which projects into a recess (36) formed on the inside face of the rigid panel (4).

12. Arrangement according to Claim 11, characterized in that the pressed-in plastic part (38) is joined to a further spacer (37) arranged on the conductor board (1).

13. Arrangement according to one of Claims 1 to 12, characterized in that a protective film (19) is arranged between the heat sink (24) and the conductor board (1) carrying the component groups (2).

**Revendications**

1. Dispositif pour refroidir des composants électroniques disposés selon des groupes sur des plaquettes à circuits imprimés, notamment des circuits intégrés à semiconducteurs, à l'aide d'un agent liquide de refroidissement, qui circule dans un corps de refroidissement ou dissipation de chaleur disposé sur le groupe de modules, et dans lequel

   a) le corps de refroidissement (24) est constitué par une feuille composite matière plastique-métal (5) fixée sur un cadre (6) et par une plaque fixe (4) disposée sur cette feuille et raccordée de façon fixe dans la zone marginale le long du pourtour et de façon étanche à la feuille,
   b) la feuille composite matière plastique-métal (5) possède un bossage (23) produit par emboutissage profond et servant à recevoir le fluide de refroidissement (30),
   c) la plaque fixe (4) possède des canaux d'alimentation (13) et au moins une arrivée (11) et une évacuation (12) pour le fluide de refroidissement (30),
   d) le corps de refroidissement est disposé, par la surface extérieure formée par la feuille composite matière plastique-métal (5) sur les groupes de composants (2,32), qui doivent être refroidis et qui sont situés sur la plaquette à circuits imprimés (1), et

   e) à l'intérieur du corps de refroidissement (24) est disposée de telle manière un matelas de compression (7) à structure en forme de grille adapté à la disposition des composants (2,32) devant être refroidis et munie des éléments saillants (22) au niveau des points de croisement de la grille, entre la feuille composite matière plastique-métal (5) et la plaque fixe (4), que la feuille composite matière plastique-métal (5) est appliquée par les éléments saillants (22) contre les différents composants (2).

2. Dispositif suivant la revendication 1, caractérisé par le fait que la feuille composite matière plastique-métal (5) possède des parties évidées (31) tournées vers l'espace intérieur du corps de refroidissement (34) et qui sont adaptées à la forme et la position des composants (32) devant être refroidis.

3. Dispositif suivant l'une des revendications 1 ou 2, caractérisé par le fait que la feuille composite matière plastique-métal (5) possède d'autres bossages (35) tournées vers l'espace intérieur du corps de refroidissement (24), ce qui conduit à la formation des sections d'étranglement pour la circulation du fluide de refroidissement.

4. Dispositif suivant l'une des revendications 1 à 3, caractérisé par le fait que la feuille composite matière plastique-métal (5) possède la succession de couches : polypropylène, aluminium, polypropylène.

5. Dispositif suivant l'une des revendications 1 à 3, caractérisé par le fait que la feuille composite matière plastique-métal (5) possède une couche superficielle en polyimide, qui est disposée sur les composants (2,32) devant être refroidis.

6. Dispositif suivant l'une des revendications 1 à 5, caractérisé par le fait que le corps de refroidissement (24) est fixé sur les groupes de composants (2), à l'aide d'un cadre de serrage (15) disposé sur le pourtour extérieur de la plaquette à circuits imprimés (1) qui porte les groupes de composants (2).

7. Dispositif suivant la revendication 6, caractérisé par le fait qu'une garniture d'étanchéité (17) est prévue entre le corps de refroidissement et la plaquette à circuits imprimés (1) de sorte que le cadre (6), qui porte la feuille composite matière plastique-métal (5), possède une rainure (9) tournée vers la plaquette à circuits imprimés (1) et contenant une bague d'étanchéité (17).

8. Dispositif suivant l'une des revendications 1 à 7, caractérisé par le fait qu'à l'intérieur du corps de refroidissement (24) est prévue, entre la plaque fixe (4) et la feuille composite matière plastique-métal (5), une entretoise (33) qui est fixée à la plaque fixe (4) et pénètre dans une partie évidée (34), dirigée vers l'extérieur, de la feuille composite matière plastique-métal (5).

9. Dispositif suivant l'une des revendications 1 à 8, caractérisé par le fait que le corps de refroidissement (24) possède un perçage traversant (20) fermé de façon étanche, prévu pour son montage commun avec la plaquette à circuits imprimés (1) sur un support.

10. Dispositif suivant l'une des revendications 1 à 9, caractérisé par le fait qu'une entretoise (35) disposée sur la plaquette à circuits imprimés (1) est prévue entre cette dernière et la plaque fixe (4) et qu'en un emplacement correspondant du corps de refroidissement (24) il est prévu une partie évidée (36) dans la plaque fixe (4), une moulure (39) de la feuille composite matière plastique-métal (5), qui est tournée vers l'espace intérieur du corps de refroidissement (24) et qui pénètre dans la partie évidée (36) de la plaque fixe (4).

11. Dispositif suivant l'une des revendications 1 à 10, caractérisé par le fait que la feuille composite matière plastique-métal (5) est fixée, en un emplacement de ses surfaces intérieures, sur la plaque fixe (4) au moyen d'une pièce en matière plastique (38), qui est enfoncée dans une autre moulure (39) de la feuille composite matière plastique-métal (5), qui est tournée vers l'espace intérieur du corps de refroidissement (24) et pénètre dans un évidement (36) ménagé dans la surface intérieure de la plaque fixe (4).

12. Dispositif suivant la revendication 11, caractérisé par le fait que la pièce en matière plastique enfoncée (38) est raccordée à une autre entretoise (37) disposée sur la plaquette à circuits imprimés (1).

13. Dispositif suivant l'une des revendications 1 à 12, caractérisé par le fait qu'une feuille de protection (19) est disposée entre le corps de refroidissement (24) et la plaquette à circuits imprimés (1) qui porte les groupes de composants (2).

# FIG 1

FIG 2

FIG 3

# FIG 4

# FIG 5

## FIG 6

## FIG 7